# EUROPEAN PATENT SPECIFICATION

(11) **EP 0 416 799 B1**
(45) Date of publication and mention of the grant of the patent: **25.01.1995**
(21) Application number: 90309418.3
(22) Date of filing: 29.08.1990
(51) Int. Cl.: C30B 15/00, C30B 15/14

(54) **A single crystal pulling apparatus**
Einkristallziehungsapparat
Appareillage pour le tirage de monocristaux

(30) Priority: 29.08.1989 JP 99822/89
(43) Date of publication of application: 13.03.1991
(73) Proprietor: SHIN-ETSU HANDOTAI COMPANY LIMITED, Chiyoda-ku Tokyo (JP)
(72) Inventor: Mizuishi, Koji, Annaka-shi, Gunma-ken (JP); Oda, Michiaki, Annaka-shi, Gunma-ken (JP)
(74) Representative: Whalley, Kevin

(56) References cited:
- FR-A- 2 276 095
- US-A- 3 679 370

## Description

The present invention relates to a single crystal pulling apparatus for pulling up a single crystal from molten liquid of a polycrystal substance based on the Czochralski method (CZ method); more particularly the invention relates to an improved single crystal pulling apparatus of this kind in which at least the heater is adapted to shift vertically and a sealing mechanism is provided to cope with the shifting of the heater.

A single crystal pulling apparatus of this kind consists mainly of a main chamber and a pull chamber, and in the main chamber are provided a crucible for containing the polycrystal raw material to be single-crystallized, a heater surrounding the crucible, a thermal insulator surrounding the heater, etc. The crucible is fixedly mounted on top of a coaxial vertical crucible shaft which is adapted to rotate about its axis. The polycrystal substance, such as silicon, put in the crucible is melted down by the heater to turn into the polycrystal molten liquid (e.g. silicon melt), and in this liquid is dipped a seed crystal fixed at the lower end of a pull means which may be a wire, etc. and the desired single crystal grows from the seed crystal as the pull means is rotated and raised at predetermined rates together with the seed crystal.

In such a conventional single crystal pulling apparatus, if the crucible were held and maintained at the original height, the melt level in the crucible would gradually shift downwards relative to the crucible wall and the heater with the growth process of the single crystal, which results in an instability of the thermal condition surrounding the as-grown crystal and the melt. Therefore, the crucible shaft is adapted to axially displace the crucible such that the downward displacement of the melt level (solid-liquid interface) is compensated for by continuously raising the crucible at a predetermined rate by a drive means so that the interface level is stationary relative to the heater during the crystal growth.

However, in the conventional single crystal pulling apparatus, the heater is stationary so that when the liquid level shifts downwards relative to the crucible wall and the crucible is lifted, the positional relationship between the heater, the crucible wall and the solid-liquid interface changes, whereby the thermal effects of the heater on the solid-liquid interface changes and this typically results in lowering of the oxygen concentration in the growing single crystal with the progress of single crystal pulling operation.

With a view to solving this problem, one of the present inventors and his colleagues employed by the same applicant of this application proposed a single crystal pulling apparatus in which the heater as well as the crucible is adapted to shift vertically (United States Patent No. US-A-5,096,677).

During a single crystal pulling operation, the atmosphere inside the chambers of the single crystal pulling apparatus is kept as inert as possible, by first rendering the atmosphere as close to vacuum as possible and then introducing an inert gas. Therefore, the chambers are made airtight by means of sealing devices. Especially in the case of the apparatus described in the foregoing paragraph, to seal the main chamber is not easy because the heater as well as the crucible is driven and shifted by means of external drive means. What has been done to seal the holes made in the bottom of the main chamber in which rod-like electrodes (19 in the figures described hereinafter) attached to the heater slide as the heater is vertically shifted, is to provide O rings to line the holes hermetically.

However, those O rings fail to perform reliably for they lose their sealing effect in relatively short times. For example, in the case of pulling up a silicon single crystal, powdery silicon oxide (SiO₂) which is created inside the chambers precipitate on the surfaces of the electrodes, and scratches and damages the O rings as the heater is shifted vertically; hence the relatively short life of the O rings. The damaged O rings allow air to leak into the chambers of the single crystal pulling apparatus whereby the single crystal being grown degrades in purity.

The present invention was made in view of the above problems, and it is, therefore, an aim of the invention to provide a single crystal pulling apparatus equipped with a sealing mechanism, which mechanism is adapted to attain improved and long-lasting sealing effect at holes made in the bottom of the main chamber in which the electrodes of the heater penetrate, so that it becomes possible to conduct the single crystal pulling operation in high vacuum stably, which results in production of single crystals of higher quality.

The present invention provides a single crystal pulling apparatus having a main chamber in which are installed a vertically shiftable crucible assembly for containing molten liquid and a vertically shiftable heater surrounding the crucible assembly and supported by a plurality of vertical electrodes which are adapted to slide through holes made in the bottom of the main chamber, said single crystal pulling apparatus being adapted to obtain a single crystal ingot by dipping a seed crystal fixed at the lower end of a pull means and pulling up the pull means to grow a single crystal ingot from the molten liquid in the crucible assembly, characterized by a sealing mechanism provided for each electrode consisting of an extensible and contractible bellows tube which surrounds the electrode and has its upper end hermetically connected to an electrically insulating connector means hermetically affixed to the main chamber and encircling the electrode, and which has its lower end hermetically connected to a connector means hermetically affixed to the electrode at a location close to the lower end of the electrode and encircling the electrode.

In a preferred embodiment, the electrically insulating connector means consists of a connector ring and a guide bush . These elements are preferably made of tetrafluoroethylene resin (Teflon), and are renewed at appropriate intervals.

According to the invention, since a bellows tube is provided for each electrode for the heater such that one end of the bellows tube is hermetically connected to an electrically insulating means hermetically integral with the main chamber and the other end thereof is hermetically connected to an element hermetically integral with the electrode, the gap between the electrode and the main chamber is completely sealed, so that no external air can enter the chamber through the places where the electrodes slidably penetrate the floor of the chamber. As a result, the O rings used to seal these places in the conventional single crystal pulling apparatus can be dispensed with, thus avoiding the problems relating to the O rings, such as the SiO₂ powder impairing the sealability of the O rings. Also, since the bellows tubes are expansible and contractible, the vertical shifting of the heater electrodes are not at all retarded in spite of the fact that one end of each bellows tube is connected to the respective electrode.

Also, the SiO₂ powder does not fall on the bellows tubes , since the falling of the powder is stopped by the guide bushes , so that the performance of the bellows tubes is not affected.

Thus, in this improved single crystal pulling apparatus, it is possible to conduct the single crystal pulling operation under a well-maintained vacuum condition, and it is possible to obtain high quality single crystal ingots reliably.

The invention will be further described, by way of example only, with example only, with reference to the accompanying drawings, in which:
Fig. 1 is a cross sectional view of a sealing mechanism of a single crystal pulling apparatus according to the present invention;
Fig. 2 is a view similar to Fig. 1 in another operating position; and
Fig. 3 is a vertical cross sectional view of a single crystal pulling apparatus equipped with the sealing mechanism of Figs. 1 and 2.

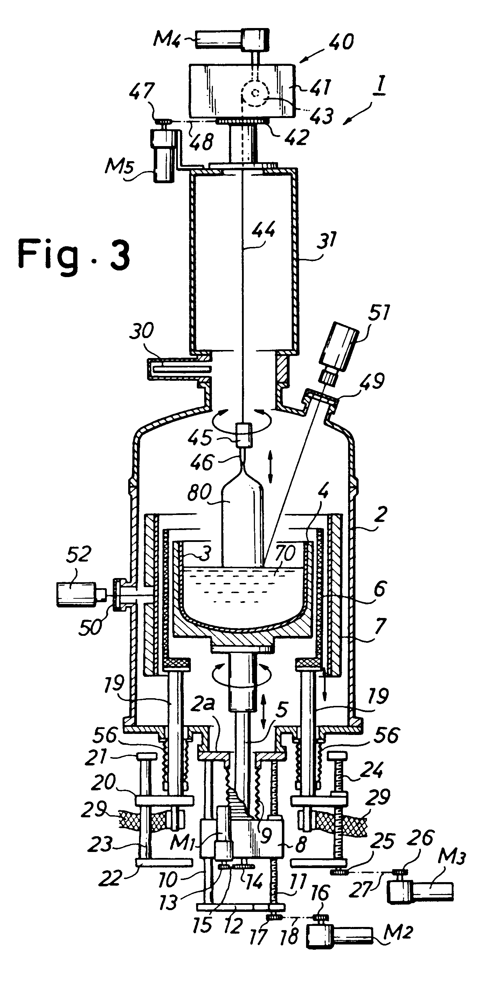

Firstly, with reference to Fig. 3, the construction of a single crystal pulling apparatus 1 will be explained. Reference numeral 2 designates a main chamber (water-cooled heating chamber) comprising mainly a stainless cylinder. Inside the main chamber 2 is a crucible assembly which consists of an internal quartz crucible 3 and an external graphite crucible 4, and is fixed on top of a vertical crucible shaft 5, which is adapted to turn about its axis and shifts vertically. Surrounding these crucibles 3, 4 are a cylindrical heater 6 made of carbon, and a cylindrical thermal insulator 7 also made of carbon. All of these elements 3, 4, 5, 6 and 7 are generally in coaxial alignment.

The crucible shaft 5 penetrates through a central bore made in a horizontal flange 2a fixed at the bottom of the main chamber 2, and extends vertically outside the main chamber 2. The lower portion of the crucible shaft 5 is pivotally supported by a slider 8. A generally cylindrical bellows tube 9, which is extensible and contractible, is attached at its upper end to the brim of the bore of the flange 2a, and at its lower end to the upper face of the slider 8 in a manner such that that portion of the crucible shaft 5 which extends below the flange 2a is entirely contained in the bellows tube 8 and such that no air leaks into the main chamber through the bore of the flange 2a.

Three vertical guide shafts 10, extending from the flange 2a, penetrate through the slider 8. A vertical ball screw 11, extending from the flange 2a, threadably penetrates through the slider 8. A circular plate 12 is fixed at the lower ends of the guide shafts 10 and the ball screw 11. A DC servomotor M₁ is provided in the slider 8 for driving the crucibles 3, 4 to rotate. An endless timing belt 15 is passed round the timing pulley 13 fixed about the end of the output shaft of the DC servomotor M₁ and a timing pulley 14 fixed at the lower end of the crucible shaft 5, which extends beyond the slider 8. The element M₂ in Fig. 3 is a DC servomotor for causing the crucibles 3, 4 to shift vertically. An endless timing belt 18 is passed round a timing pulley 16 fixed at the end of the output shaft of the servomotor M₂ and a timing pulley 17 fixed at the lower end of the ball screw 11 which extends beyond the plate 12 downward.

The heater 6 is supported by a pair of vertical electrodes 19, 19, which slidably penetrate the bottom of the chamber with their upper ends disposed in the chamber 2. A horizontal ring plate 20 is fixed at the lower ends of the electrodes 19. Three vertical guide shafts 23 slidably penetrate the ring plate 20, and are fixed between two stationary and horizontal ring plates 21 and 22, which former lies above, and which latter lies below, the ring plate 20. A vertical ball screw 24 has its ends freely pivotally borne in the ring plates 21 and 22, and threadably penetrates the intermediate ring plate 20. A timing pulley 25 is fixed at the lower end of the ball screw 24 that extends beyond the ring plate 22 downwardly, and an endless timing belt 27 is wound around the timing pulley 25 and a timing pulley 26 fixed at the end of the output shaft of a DC servomotor M₃ . This servomotor M₃ is for causing the heater 6 to shift vertically.

Flexible lead bands 29 are electrically connected to the lower ends of the electrodes 19 for providing electric power to the electrodes 18 to electrify the heater 6, and are connected at the other ends to a power source, not shown.

A pull chamber 31 is provided on top of the main chamber 2 in a coaxial alignment, and an isolation valve is provided between the two chambers 2, 31. A winder assembly 40 is provided at the top portion of the pull chamber 31. The pull chamber 31 comprises a stainless cylinder, and is for receiving in it the pulled-up grown single crystal ingot (rod), and for providing a lateral exit for the ingot.

A box 41 of the winder assembly 40 is adapted to rotate horizontally relative to the pull chamber 31 together with a timing pulley 42, which is fitted on the bottom of the box 41. Provided in the box 41 is a wire winder drum 43 which is freely rotatable about its axis. A DC servomotor M₄ is provided above the box 41 for causing the wire winder drum 43 to rotate.

A pull wire 44 is wound round the drum 43, and a part of it is unwound to suspend vertically past the pull chamber 31 and into the heat chamber 2. A seed holder 45 is provided at the lower end of the wire 44 for holding a seed crystal 46.

A DC servomotor M₅ is provided at the top of the pull chamber 31 for causing the box 41 to rotate to thereby spin the wire 44 by virtue of an endless belt 48 passed around a timing pulley 47 fixed at the end of the output shaft of the servomotor M₅ and the timing pulley 42.

A sight glass 49 is provided in the roof of the chamber 2, and an optical diameter detecting means 51 is provided at the sight glass 49 to observe therethrough. Another sight glass 50 is provided in the side wall of the chamber 2, and an optical temperature detecting means 52 is provided at the sight glass 50 to observe therethrough.

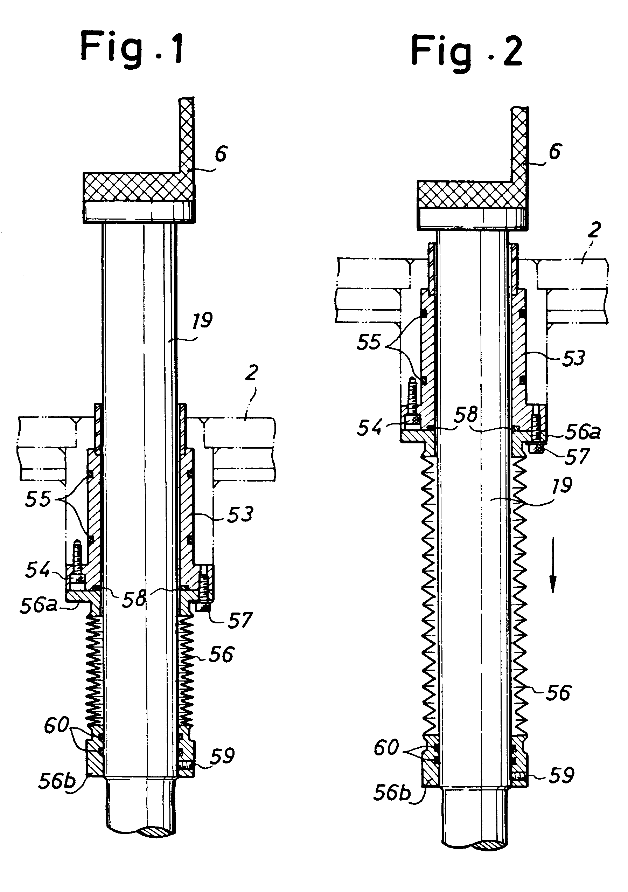

Now, with reference to Fig. 1 and Fig. 2, the sealing devices provided at the places where the electrodes 19 penetrate the bottom of the chamber 2 will be described.

The electrodes 19 are made of copper, and cooling water is circulated inside the electrodes 19. An electrically insulating guide bush 53 is fitted in each sleeve formed at the bores made in the bottom of the chamber 2 through which the electrodes 19 penetrate. Each guide bush 53 is bolted to the sleeve by means of bolts 54, and has two grooves to receive two O rings 55, 55 which seal the clearance between the guide bush 53 and each sleeve extending from the floor of the chamber 2. Besides the electrically insulating property, the material for the guide bushes 53 ought to have high heat resisting and corrosion resisting properties, as well as such surface properties that it does not flaw, nor apply too much friction to the sliding electrode 19. To meet these requirements, a preferable material is tetrafluoroethylene resin (Teflon). These guide bushes ought to be replaced by new ones at appropriate intervals.

A connector ring 56a is fixed to the bottom face of the guide bush 53 by means of bolts 57, and an O ring 58 is provided in a groove made in the bottom face of the guide bush 53 to seal the clearance between the mating faces of the connector ring 56a and the guide bush 53. The inner diameter of the connector ring 56a is greater than the outer diameter of the electrode 19 so that the electrode 19 can freely pass through the connector ring 56a. The connector ring 56a is also preferably made of tetrafluoroethylene resin.

A connector ring 56b is fixed on each electrode 19 at a location substantially close to the lower end thereof, by means of a machine screw 59. Two O rings 60, 60 are provided in grooves made in the inner wall of the connector ring 56b to seal the clearance between the electrode 19 and the connector ring 56b.

A bellows tube 56 which is extensible and contractible is connected between the connector rings 56a, 56b, such that the bellows tube 56 covers nearly entirely that portion of each electrode 19 which extends beyond the sleeve of the chamber 2. The upper end of the bellows tube 56 is connected to the connector ring 56a and the lower end is connected to the connector ring 56b.

Next, the operation of the single crystal pulling apparatus 1 will be described.

At the beginning of the single crystal pulling operation, the isolation valve 30 is opened to thereby render the main chamber 2 and the pull chamber 31 into communication. Then, the air in the chambers 2 and 31 is drawn out until the internal pressure of the chambers becomes sufficiently low. Then an inert gas, such as argon gas, is supplied to the chamber 2, and the single crystal pulling operation is carried out in this inert gas atmosphere.

Polycrystal raw material such as silicon is charged in the crucible 3 wherein it is melted by the heater 6 to form a molten liquid 70. The pulling operation starts as the motor M₄ drives the wire winder drum 43 to turn in the direction of unwinding the pull wire 44. Thus, the wire 44 is lowered gradually, and the seed crystal 46 fixed at the lower end of the wire 44 is dipped in the molten liquid 70 contained in the crucible 3.

Next, the motor M₁ is started, and its torque is transmitted to the crucible shaft 5 by way of the pulley 13, the timing belt 15, and the pulley 14, whereupon the crucible shaft 5 and the crucibles 3, 4 supported thereon are caused to rotate about their common axis of rotation at a predetermined rate. Simultaneously with this, the motors M₄ and M₅ are started. The torque of the motor M₄ is transmitted to and causes the wire winder drum 43 to turn and wind up the pull wire 44 at a predetermined velocity. The torque of the motor M₅ is transmitted, via the pulley 47, the timing belt 48, and the pulley 42, to and causes the box 41 of the winder assembly 40 to turn around its rotation axis. Thus, the pull wire 44 also spins together with the box 41 at a predetermined rate. As a result, the pull wire 44 rises and spins at the same time, and a single crystal rod 80 grows from the seed crystal 46 provided at the end of the pull wire 44, as shown in Fig. 3.

As the pulling of the single crystal 80 proceeds, the level of the molten liquid 70 shifts downward relative to the wall of the crucible 3, and in order to maintain the level of the molten liquid 70 unchanged relative to the chamber 2, the crucibles 3, 4 are raised at a predetermined velocity which is identical to the velocity at which the level of the molten liquid 70 goes down in the crucible 3. In particular, the motor M₂ is started and its torque is transmitted, via the pulley 16, timing belt 18 and pulley 17, to and causes the ball screw shaft 11 to turn in a direction such that the slider 8 rises along the guide shafts 10, whereby the crucible shaft 5 supported by the slider 8 and the crucibles 3, 4 mounted on the crucible shaft 5 rise at the said predetermined velocity.

In the present embodiment, the heater 6 is also shifted downwardly at a predetermined velocity during the single crystal pulling operation. In particular, the motor M₃ is started and its rotational torque is transmitted, via the pulley 26, the timing belt 27, and the pulley 25, to and causes the ball screw shaft 24 to turn in a direction such that the plate 20 shifts downwardly along the guide shafts 23, whereby the electrodes 19, 19 supported by the plate 20 and the heater 6 descend at the predetermined velocity.

According to the present embodiment of the invention, since a bellows tube 56 is provided for each heater electrode 19 such that one end of the bellows tube is hermetically connected to an element (56a) integral with the main chamber 2 and the other end thereof is hermetically connected to an element (56b) integral with the electrode 19, the gap between the electrode 19 and the main chamber 2 is completely sealed, so that no external air can enter the chamber 2 through the places where the electrodes 19 slidably penetrate the floor of the chamber 2. As a result, the O rings used to seal these places in the conventional single crystal pulling apparatus are no longer needed, and can be removed together, thus avoiding the problems relating to the O rings, such as the SiO₂ powder damaging the O rings. Also, the SiO₂ powder does not fall on the bellows tubes 56, since the falling of the powder is stopped by the guide bushes 53, so that the performance of the bellows tubes 56 is not affected. Thus, in this improved single crystal pulling apparatus, it is possible to conduct the single crystal pulling operation under a well-maintained vacuum condition, and it is possible to obtain high quality single crystal ingots reliably.

While there has been described what is at present considered to be the preferred embodiment of the invention, it will be understood that various modifications may be made therein.

## Claims

1. A single crystal pulling apparatus having a main chamber (2) in which are installed a vertically shiftable crucible assembly (3, 4) for containing molten liquid (70) and a vertically shiftable heater (6) surrounding the crucible assembly and supported by a plurality of vertical electrodes which are adapted to slide through holes made in the bottom of the main chamber, said single crystal pulling apparatus being adapted to obtain a single crystal ingot by dipping a seed crystal (46) fixed at the lower end of a pull means (44, 45) and pulling up the pull means to grow a single crystal ingot from the molten liquid in the crucible assembly, characterized by a sealing mechanism provided for each electrode consisting of an extensible and contractible bellows tube (56) which surrounds the electrode and has its upper end hermetically connected to an electrically insulating connector means (53, 56a) hermetically affixed to the main chamber and encircling the electrode, and which (56) has its lower end hermetically connected to a connector means (56b) hermetically affixed to the electrode at a location close to the lower end of the electrode and encircling the electrode.

2. A single crystal pulling apparatus as claimed in claim 1, characterized in that the electrically insulating connector means consists of a connector ring (56a) and a guide bush (53) which latter is fitted in a sleeve extending downward from the main chamber.

3. A single crystal pulling apparatus as claimed in claim 2, characterized in that said connector ring is made of tetrafluoroethylene resin.

4. A single crystal pulling apparatus as claimed in claim 2, characterized in that said connector ring and said guide bush are made of tetrafluoroethylene resin.

## Revendications

1. Un appareil de tirage de monocristaux comportant une chambre principale (2), dans laquelle sont installés un assemblage de creuset pouvant être déplacé verticalement (3,4), destiné à contenir le liquide fondu (70) et un dispositif de chauffage pouvant se déplacer verticalement (6), entourant l'assemblage de creuset et supporté par plusieurs électrodes verticales, pouvant glisser à travers les trous pratiqués dans le fond de la chambre principale, ledit appareil de tirage de monocristaux permettant de produire un lingot monocristallin par immersion d'un germe cristallin (46), fixé à l'extrémité inférieure d'un moyen de tirage (44, 45), et par remontée du moyen de tirage pour tirer un lingot monocristallin à partir du liquide fondu dans l'assemblage de creuset, caractérisé par l'agencement d'un mécanisme d'étanchéité pour chaque électrode, composé d'un tube à soufflet pouvant se dilater et se contracter (56), entourant l'électrode et dont l'extrémité supérieure est connectée hermétiquement à un moyen de connexion à isolement électrique (53, 56a), fixé hermétiquement à la chambre principale et encerclant l'électrode, ce tube (56) comportant une extrémité inférieure connectée hermétiquement à un moyen de connexion (56b), fixé hermétiquement à l'électrode en un emplacement proche de l'extrémité inférieure de l'électrode et encerclant l'électrode.

2. Un appareil de tirage de monocristaux selon la revendication 1, caractérisé en ce que le moyen de connexion à isolement électrique se compose d'une bague de connexion (56a) et d'une douille de guidage (53), cette dernière étant agencée dans un manchon s'étendant vers le bas à partir de la chambre principale.

3. Un appareil de tirage de monocristaux selon la revendication 2, caractérisé en ce que ladite bague de connexion est composée de résine de tétrafluoréthylène.

4. Un appareil de tirage de monocristaux selon la revendication 2, caractérisé en ce que ladite bague de connexion et ladite douille de guidage sont composés de résine de tétrafluoréthylène.

## Patentansprüche

1. Einkristallziehapparat, der eine Hauptkammer (2) aufweist, in der installiert sind: eine vertikal verschiebbare Tiegelbaugruppe (3, 4) für die Aufnahme der geschmolzenen Flüssigkeit (70) und ein vertikal verschiebbarer Heizkörper (6), der die Tiegelbaugruppe umgibt und durch eine Vielzahl von vertikalen Elektroden getragen wird, die so konstruiert sind, daß sie durch die Löcher hindurchgleiten, die im Boden der Hauptkammer vorhanden sind, wobei der Einkristallziehapparat so konstruiert ist, daß ein Einkristallblock durch Tauchen eines Kristallkeimes (46), der am unteren Ende einer Ziehvorrichtung (44, 45) befestigt ist, und Ziehen der Ziehvorrichtung nach oben erhalten wird, damit ein Einkristallblock aus der geschmolzenen Flüssigkeit in der Tiegelbaugruppe wächst; gekennzeichnet durch einen Abdichtmechanismus, der für jede Elektrode bereitgestellt wird, und der aus eins ausdehnbaren und zusammenziehbaren Wellrohr (56) besteht, das die Elektrode umgibt, und dessen oberes Ende hermetisch mit einem elektrisch isolierenden Verbindungsstück (53, 56a) verbunden ist, das hermetisch an der Hauptkammer befestigt ist und die Elektrode umgibt, und wobei das untere Ende von (56) hermetisch mit einem Verbindungsstück (56b) verbunden ist, das hermetisch an der Elektrode an einer Stelle befestigt ist, die nahe am unteren Ende der Elektrode zu finden ist und die Elektrode umgibt.

2. Einkristallziehapparat nach Anspruch 1, dadurch gekennzeichnet, daß das elektrisch isolierende Verbindungsstück aus einem Verbindungsring (56a) und einer Führungsbuchse (53) besteht, wobei letztere in eine Hülse eingepaßt ist, die sich von der Hauptkammer aus nach unten zu erstreckt.

3. Einkristallziehapparat nach Anspruch 2, dadurch gekennzeichnet, daß der Verbindungsring aus Tetrafluoräthylenharz besteht.

4. Einkristallziehapparat nach Anspruch 2, dadurch gekennzeichnet, daß der Verbindungsring und die Führungsbuchse aus Tetrafluoräthylenharz bestehen.
